# EUROPÄISCHE PATENTSCHRIFT

(11) **EP 2 203 937 B1**
(45) Veröffentlichungstag und Bekanntmachung des Hinweises auf die Patenterteilung: **14.11.2018**
(21) Anmeldenummer: 08803570.4
(22) Anmeldetag: 03.09.2008
(51) Int. Cl.: H01L 25/07, H01L 25/16, H05K 1/03, H05K 1/14, H05K 3/00, H05K 3/32

(54) **VERFAHREN ZUR HERSTELLUNG EINER ELEKTRONISCHEN SCHALTUNG AUS TEILSCHALTUNGEN**
METHOD FOR PRODUCING AN ELECTRONIC CIRCUIT COMPOSED OF SUB-CIRCUITS
PROCÉDÉ DE FABRICATION D'UN CIRCUIT ÉLECTRONIQUE COMPOSÉ DE SOUS-CIRCUITS

(30) Priorität: 28.09.2007 DE 102007046969
(43) Veröffentlichungstag der Anmeldung: 07.07.2010
(73) Patentinhaber: Siemens Aktiengesellschaft, 80333 München (DE)
(72) Erfinder: BIRNER, Martin, 92242 Hirschau (DE); KREUTZER, Rainer, 92637 Weiden (DE); SCHIERLING, Hubert, 91052 Erlangen (DE); SELIGER, Norbert, 85604 Zorneding (DE)
(86) Internationale Anmeldenummer: PCT/EP2008/061599
(87) Internationale Veröffentlichungsnummer: WO 2009/043670

(56) Entgegenhaltungen:
- WO-A-02/49104
- DE-A1-102004 061 907
- US-A1- 2006 001 152
- US-B1- 6 207 221

## Beschreibung

Die Erfindung betrifft ein Verfahren zur Herstellung einer elektronischen Schaltung.

Bei der Herstellung elektronischer Schaltungen besteht ein Trend zur immer höheren Integration, d.h. dazu, immer mehr elektronische Bauteile wie beispielsweise Halbleiterchips auf einem Träger für die elektronische Schaltung, beispielsweise einem Keramiksubstrat, unterzubringen und somit immer komplexere und umfangreichere elektronische Schaltungen zu schaffen. Obwohl die Ausbeute bei der Herstellung einer elektronischen Schaltung durch die hohe Integration und Komplexität sinkt, wird dadurch doch eine insgesamt kostengünstigere Herstellung erreicht.

Bei leistungselektronischen Schaltungen, d.h. solchen mit Bauteilen der Leistungselektronik, besteht eine besondere Randbedingung für die Herstellung darin, dass bei der leistungselektronischen Schaltung eine erhebliche Menge an Verlustwärme auftritt. Dadurch ist die mögliche Packungsdichte für die leistungselektronischen Bauteile begrenzt, da deren Verlustwärme abgeführt werden muss und die Temperatur der leistungselektronischen Bauteile vor allem bei Halbleiterbauelementen bestimmte Temperaturgrenzen nicht überschreiten darf. Bedingt dadurch führt eine zunehmende Integration von komplexeren Schaltungen auf einem Substrat zu insgesamt vergrößerten Schaltungen. Solche haben aber wiederum eigene Nachteile. So ist die Zuverlässigkeit einer solchen Anordnung speziell bei zyklischer thermischer Belastung reduziert, da leicht eine Ermüdung an der Grenzfläche zwischen isolierendem Trägermaterial und Kupferschicht eintritt. Auch führt die hohe Arbeitstemperatur leistungselektronischer Schaltungen zu einer Verwölbung von großflächigen Substraten, was eine Wärmeabfuhr erschwert.

Schließlich hängt die Wärmeabfuhr auch von der möglichst guten mechanischen Verbindung zwischen
einem Kühler und dem Substrat ab. Je größer das Substrat, desto höher sind die Anforderungen an den damit verbundenen Kühler, beispielsweise die Ebenheit der Oberfläche des Kühlers.

Aus der US 2006/0001152 A1 ist ein Multi-Chip Halbleiter-Struktur mit direkten Verbindungen bekannt. Dabei wird eine Mehrzahl von Halbleiter-Chips auf einen metallischen Kühlkörper aufgebracht. Leiterstrukturen, die sich über die Chips hinaus erstrecken, erlauben eine Kontaktierung der Chips.

Aus der WO 02/49104 A2 ist ein Leistungsmodul bekannt. Das Leistungsmodul besteht aus mindestens einem elektronischen Leistungsbauelement, einem DCB-Keramiksubstrat, einem Kühlkörper und mindestens einer zusätzlichen Wärmekapazität, wobei die elektronischen Leistungsbauelemente über eine Sinterschicht an ihrer Unterseite mit der oberen Kupferschicht des DCB-Keramiksubstrates verbunden sind, die obere Kupferschicht des DCB-Keramiksubsträtes zur elektrischen Kontaktierung der Leistungsbauelemente in Kupferleiterbahnen strukturiert ist, die untere Kupferschicht des DCB-Keramiksubstrates über eine Sinterschicht mit einen Kühlkörper verbunden ist und die Oberseiten der Leistungsbauelemente über eine Sinterschicht mit einer zusätzlichen Wärmekapazität Verbunden sind.

Aus der US 6,207,221 B1 ist ein Verfahren zur Herstellung eines Keramik-Metall-Substrats bekannt. Dabei wird eine Keramikschicht beidseitig mit einer Metallschicht, beispielsweise einer Kupferfolie überzogen. Aus der DE 10 2004 061 907 A1 ist ein Verfahren zur Herstellung von Halbleiterleistungsmodulen bekannt, bei dem die Leistungsbauelemente beabstandet auf ein gemeinsames Substrat aufgebracht werden. Dabei wird jedem Bauelement einzeln oder allen gemeinsam ein DCB-Substrat zugeordnet. Die der Erfindung zugrunde liegende Aufgabe ist es, ein Verfahren anzugeben, mit dem eine elektronische Schaltung hergestellt werden kann, die die oben angegebenen Nachteile weitgehend vermeidet oder vermindert.

Hinsichtlich des Verfahrens wird die Aufgabe durch ein Verfahren mit den Merkmalen von Anspruch 1 gelöst. Die abhängigen Ansprüche betreffen vorteilhafte Ausgestaltungen und Weiterbildungen der Erfindung.

Bei dem erfindungsgemäßen Herstellungsverfahren für eine elektronische Schaltung werden in einem ersten Schritt wenigstens zwei elektronische Teilschaltungen hergestellt, wobei die Teilschaltungen jeweils mehrere elektronische Bauelemente auf einem separaten isolierenden Teilträger aufweisen. In einem zweiten Schritt werden die Teilschaltungen nebeneinander auf einem gemeinsamen Träger angeordnet. In
einem dritten Schritt werden die Teilschaltungen mit einem Verfahren zur flächigen Kontaktierung elektrisch verbunden, wobei das Verfahren zur flächigen Kontaktierung wenigstens das Abscheiden einer metallischen Schicht umfasst. Dabei werden wenigstens zwei identische Teilschaltungen in einem gemeinsamen Prozess hergestellt und allein oder zusammen mit weiteren Teilschaltungen zur elektronischen Schaltung verbunden.

Bei den isolierenden Teilträgern kann es sich beispielsweise um einfache Keramiksubstrate handeln. Es kann sich weiterhin beispielsweise um DCBs (DCB = Direct Copper Bonding) handeln. Ein DCB weist typischerweise ein isolierendes Keramiksubstrat in Verbindung mit zwei auf jeder Seite des Substrats aufgebrachten flächigen Kupferleiterbahnen auf. Auf den Teilträgern befinden sich ein oder mehrere elektronische Bauelemente wie beispielsweise Widerstände, Kondensatoren, Dioden oder Transistoren. Neben einzelnen elektronischen Bauelementen können die Teilträger auch ganze Chips aufweisen, die selbst wiederum ein oder mehrere elektronische Bauelemente enthalten.

Die Teilschaltungen werden erfindungsgemäß nebeneinander, d.h. benachbart zueinander, auf einem gemeinsamen Träger angeordnet. Eine sehr dichte Anordnung der Teilschaltungen aneinander sorgt dabei vorteilhaft für eine geringe Größe der elektronischen Schaltung. Alternativ führt jedoch ein größerer Abstand zwischen den Teilschaltungen zu einer verbesserten Verteilung von Verlustwärme, die bei den Teilschaltungen entsteht. Bei der metallischen Schicht, die für eine elektrische Verbindung zwischen den Teilschaltungen sorgt, handelt es sich bevorzugt um eine Schicht aus Kupfer.

Das erfindungsgemäße Herstellungsverfahren und die daraus sich ergebende elektronische Schaltung weisen eine Reihe von Vorteilen auf. So ist die gesamte elektronische Schaltung in kleinere Teilschaltungen zerlegt, wobei die kleineren Teilschaltungen insgesamt zu einer erhöhten Zuverlässigkeit der gesamten elektronischen Schaltung führen, da eine zyklische thermische Belastung der Teilschaltungen zu einer reduzierten Materialermüdung führt. Weiterhin verwölben die kleineren Teilschaltungen bei erhöhter Betriebstemperatur weniger stark, als eine große Gesamtschaltung dies tun würde. Hierdurch ist zum einen eine bessere Wärmeabfuhr möglich, wenn beispielsweise eine Teilschaltung in Kontakt mit einem Kühler steht. Weiterhin sind reduzierte Anforderungen an die Oberfläche eines solchen Kühlers zu stellen, beispielsweise an seine Ebenheit.

Die flächige metallische Schicht, die der elektrischen Verbindung der Teilschaltungen dient, sorgt weiterhin für eine niederinduktive Verbindung zwischen den Teilschaltungen.

Auch wird die Prozessierung solcher Schaltungen günstiger, da eine optimale Ausnutzung eines Nutzens durch die Kombination verschiedener Schaltungsmöglichkeiten erreicht wird. Der Aufbau aus Teilschaltungen ermöglicht darüber hinaus eine Modularität im Leistungsspektrum, da durch beispielsweise eine Parallelschaltung von zwei oder mehreren identischen Teilschaltungen elektronische Schaltungen mit höherer Gesamtleistung hergestellt werden können. Schließlich ergibt sich eine Verbesserung dadurch, dass eine Grundform des Teilträgers
ideal ausgenutzt wird. So kann als Beispiel als Teilträger ein DCB zum Einsatz kommen, das ideal genutzt wird, während als gemeinsamer Träger ein einfacherer Substrattyp wie beispielsweise ein einfaches Keramiksubstrat verwendet werden kann.

Besonders vorteilhaft ist es, wenn wenigstens ein Teil der Bauteile, die auf den Teilschaltungen vorgesehen sind, solche der Leistungselektronik sind. Bei der elektronischen Schaltung handelt es sich somit um eine leistungselektronische Schaltung. Gerade leistungselektronische Schaltungen weisen meistens eine hohe Betriebstemperatur von 100°C oder mehr auf. Die bereits eingangs genannten Vorteile der elektronischen Schaltung bzw. des Herstellungsverfahrens gelten in diesem Fall ganz besonders. Insbesondere ist durch die im Vergleich zur gesamten Schaltung kleinen Teilschaltungen die durch die Arbeitstemperatur entstehende Verwölbung verringert und dadurch die Wärmeabfuhr verbessert. Weiterhin sind dadurch auch die Anforderungen an den Aufbau eines Kühlers verringert.

In einer weiteren vorteilhaften Ausgestaltung und Weiterbildung der Erfindung werden mit der flächigen Kontaktierung auch eine oder mehrere elektrische Verbindungen innerhalb der Teilschaltungen hergestellt. Das bedeutet, dass beispielsweise eine vorherige Verdrahtung oder anderweitige Kontaktierung innerhalb der Teilschaltungen unterbleiben kann, da diese durch die flächige Kontaktierung hergestellt wird. Dies führt zu einer besonderen Vereinfachung bei der Herstellung der elektronischen Schaltung und somit zu einer besonderen Einsparung von Kosten und Ressourcen. Bevorzugt werden dabei mit der flächigen Kontaktierung auch elektrische Verbindungen zu Anschlussklemmen oder anderen Verbindungselementen hergestellt.

In einer weiteren vorteilhaften Ausgestaltung und Weiterbildung der Erfindung handelt es sich bei dem gemeinsamen Träger um einen Kühlkörper. Ein Beispiel für einen solchen Kühlkörper ist ein mit Kühlrippen versehener Block aus Kupfer oder Edelstahl. Hierdurch wird vorteilhaft die Verwendung eines weiteren isolierenden Substrats, das Kosten verursacht, vermieden. Weiterhin ermöglicht der direkte Aufbau der Teilschaltungen auf einem Kühlkörper eine ideale Verteilung von in den Teilschaltungen entstehender Verlustwärme.

In einer besonders bevorzugten Ausgestaltung der Erfindung wird zur Herstellung der flächigen Kontaktierung zuerst eine Isolationsfolie zur elektrischen Isolation auf dem gemeinsamen Träger und die darauf befindlichen Teilschaltungen aufgebracht. Weiterhin wird die metallische Schicht, die Teil der flächigen Kontaktierung ist und für die elektrische Verbindung sorgt, galvanisch auf die Isolationsfolie aufgebracht. Um eine elektrische Verbindung zu unter der Isolationsfolie liegenden Kontaktflächen zu erreichen, werden nach Aufbringen der Isolationsfolie in dieser an geeigneten Stellen Fenster geöffnet. Weiterhin ist es bevorzugt möglich, vor dem galvanischen Aufbringen der metallischen Schicht eine metallische Starterschicht aufzubringen, beispielsweise durch Sputtern. Die Isolationsfolie erlaubt hier vorteilhafterweise eine elektrische Isolation von der metallischen Schicht und bereits vorhandenen leitfähigen Schichten, wie beispielsweise einer Kupfer-Basis-Schicht eines DCB, das als Teilträger verwendet wird. Das galvanische Aufbringen der metallischen Schicht ist eine schonende Vorgehensweise, bei der dennoch Schichten mit hohen Dicken von bis zu 500 µm erzeugt werden können.

In einer weiteren vorteilhaften Ausgestaltung der Erfindung wird nach dem Aufbringen der metallischen Schicht eine weitere elektrisch isolierende Schicht auf den bisherigen Aufbau aufgebracht. Die weitere elektrisch isolierende Schicht bedeckt also die metallische Schicht, die darunter liegende
isolierende Schicht, sowie alle Teilschaltungen und den gemeinsamen Träger.

Besonders vorteilhaft ist es, wenn zwei, mehrere, oder alle der Teilschaltungen der elektronischen Schaltung identisch sind. Dies führt zu einer wesentlich effizienteren Herstellung, da der Ausschuss bei der Prozessierung der Teilschaltungen deutlich geringer ausfällt als bei einer Prozessierung von entsprechend größeren gesamten elektronischen Schaltungen. Ein weiterer Vorteil besteht in einer erhöhten Flexibilität des Schaltungsaufbaus. Das liegt daran, dass aus den identischen Teilschaltungen durch eine Änderung der Substratverbindung oder durch eine Anpassung der Anzahl der Teilschaltungen angepasste oder veränderte elektronische Schaltungen hergestellt werden können. Beispielsweise kann aus
einer einphasigen Schaltung durch eine Parallelanordnung von mehreren der entsprechenden verwendeten Teilschaltungen eine mehrphasige gleichartige Schaltung gemacht werden. Als weiteres Beispiel kann durch eine Veränderung der elektrischen Verbindung der Teilschaltungen aus einer mehrphasigen Schaltung eine einphasige Schaltung hergestellt werden. Eine weitere Möglichkeit besteht darin, durch eine Parallelschaltung von gleichartigen Schaltungen eine Schaltung mit höherer Leistungskapazität herzustellen.

Bevorzugt werden die Teilschaltungen mit Halterungen auf dem gemeinsamen Träger verankert. Alternativ können sie auch mit einer Lötverbindung, Klebeverbindung oder anderen Verbindung verankert werden. Im Falle eine Schaltung mit Leistungshalbleiter-Bauelementen ist es vorteilhaft, wenn die Verbindung eine hohe Wärmeleitfähigkeit aufweist, um eine gute Spreizung der Abwärme der Bauelemente zu erlauben. Die Verwendung von Halterungen hat jedoch den Vorteil, weniger anfällig gegen thermomechanische Belastungen zu sein und eine bessere thermische Kopplung zum gemeinsamen Träger herzustellen.

Weitere Vorteile und Einzelheiten werden anhand von in den Zeichnungen dargestellten Ausführungsbeispielen erläutert. Dabei zeigen
- Figur 1: eine Teilschaltung auf einem DCB,
- Figur 2: mehrere auf einem Kühlkörper angeordnete Teilschaltungen unter einem Isolationsschichtaufbau mit elektrischen Verbindungen,
- Figur 3: den Aufbau des Isolationsschichtaufbaus,
- Figur 4: zwei Möglichkeiten für den Aufbau der Teilschaltungen mit Halterungen,
- Figur 5: ein Schaltbild für einen modularisierbaren dreiphasigen Schalter,
- Figur 6: ein Schaltbild für ein modularisierbares dreiphasiges Umrichtersystem,
- Figur 7: den modularisierten Aufbau mit Teilschaltungen des dreiphasigen Schalters,
- Figur 8: den modularisierten Aufbau aus Teilschaltungen des Umrichtersystems,
- Figur 9: den modularisierten Aufbau einer Teilschaltung des Umrichtersystems und des dreiphasigen Schalters,
- Figur 10: ein Schaltbild für die Teilschaltung.

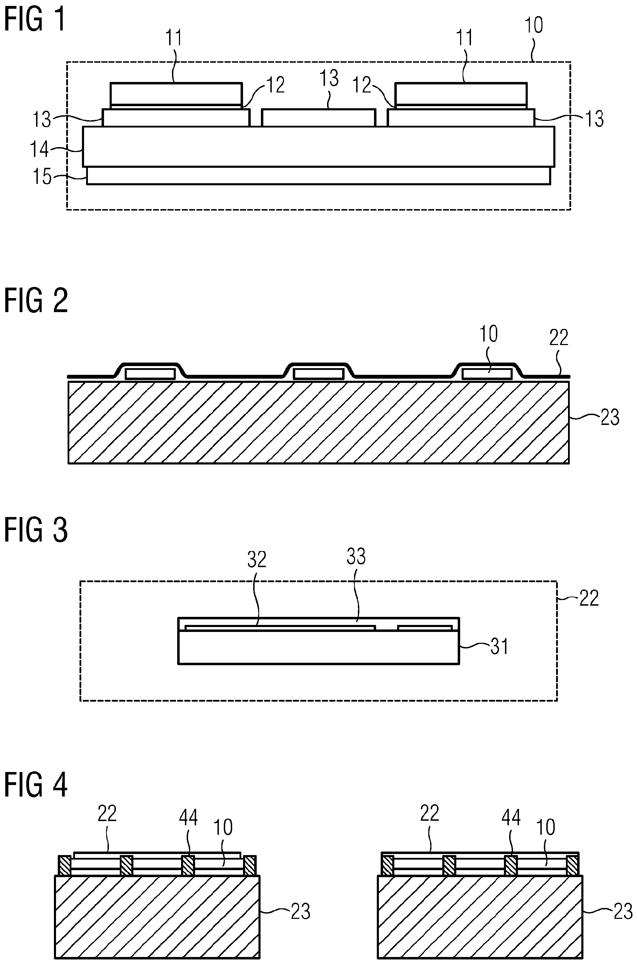

Die Figur 1 zeigt eine beispielhafte Teilschaltung 10 in Seitenansicht, wie sie aufgebaut sein kann. Die Teilschaltung 10 besteht aus einem DCB-Substrat 14, das auf der Unterseite eine unstrukturierte untere KupferLeiterbahn 15 aufweist. Auf der Oberseite weist das DCB-Substrat 14 eine strukturierte obere Kupferleiterbahn 13 auf. Auf der oberen Kupferleiterbahn 13 sind mittels Lotschichten 12 zwei Halbleiter-Chips 11 aufgebracht. Die obere Kupferleiterbahn 13 dient hierbei beispielhaft zu einer elektrischen Verbindung von elektrischen Anschlüssen auf der Unterseite der Halbleiterchips 11. Eine mögliche Alternative hierzu besteht darin, dass die obere Kupferleiterbahn 13 keine elektrische Verbindung herstellt, sondern nur der Ableitung von Verlustwärme der Halbleiterchips 11 dient. In diesem Fall ist es zweckmäßig, wenn die obere Kupferleiterbahn 13 keine Strukturierung aufweist.
In diesem Beispiel soll einer der beiden Halbleiterchips 11 eine Diode 56 enthalten, während der andere Halbleiterchip 11 einen IGBT (IGBT = Insulated Gate Bipolar Transistor) enthält. Es ist klar, dass dieser Aufbau nur beispielhaft ist und in anderen Ausführungsvarianten auch Halbleiterchips 11 mit wesentlich mehr und/oder komplexeren Aufbauten, auch im Gemisch mit einzelnen elektronischen Bauteilen, verwendet werden können.

Eine beispielhafte Aufbaumöglichkeit einer elektronischen Schaltung ist in Seitenansicht in Figur 2 gezeigt. Die elektronische Schaltung basiert auf einem Kühlkörper 23 und weist drei nebeneinander liegende Teilschaltungen 10 auf, die auf dem Kühlkörper vorgesehen sind. Der Kühlkörper 23 und die darauf befindlichen Teilschaltungen 10 werden von einem Schichtaufbau 22 bedeckt, der gleichermaßen der elektrischen Isolation und der elektrischen Verbindung dient. Der genaue Aufbau des Schichtaufbaus 22 ist in Figur 3 gezeigt. Der Schichtaufbau 22 besteht aus einem Dielektrikum 31, auf das eine strukturierte, flächige Kupferleiterbahn 32 aufgebracht ist. Das Dielektrikum 31 und die flächige Kupferleiterbahn 32 werden wiederum von einer isolierenden Deckschicht 33 bedeckt. Das Dielektrikum 31 und die isolierende Deckschicht 33 sind als Kunststofffolien ausgeführt und können somit beispielsweise nacheinander unter Einbringung der flächigen Kupferleiterbahn 32 auf den Kühlkörper 23 mit den Teilschaltungen 10 auflaminiert werden.
Gemäß Figur 4 werden die Teilschaltungen 10 auf dem Kühlkörper 23 mittels Halterungen 44 fixiert. Dabei sind gemäß Figur 4 die Teilschaltungen 10 und die Halterungen 44 direkt benachbart aneinander angeordnet, so dass der

Schichtaufbau 22, der wiederum die Teilschaltungen 10 und die Halterungen 44 bedeckt, nur in geringem Maße Höhenunterschiede überwinden muss.

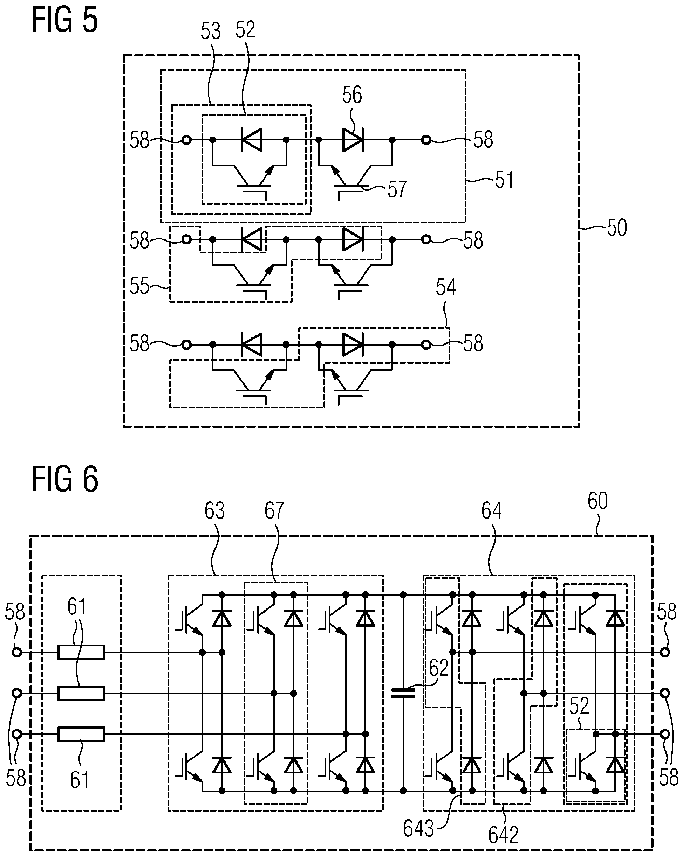

Im Folgenden werden konkrete Beispiele für modularisierbare Schaltungen 50, 60 sowie deren konkrete Umsetzung mittels Teilsubstraten 10 gezeigt. In Figur 5 ist ein dreiphasiger Schalter 50 schematisch dargestellt. Der dreiphasige Schalter 50 besteht aus drei elektrisch unabhängigen einphasigen Schaltern 51. Jeder der einphasigen Schalter 51 weist zwei Anschlussklemmen 58 auf. Die Anschlussklemmen 58 sind über zwei Halbschaltermodule 52 miteinander verbunden, wobei die Halbschaltermodule 52 antiseriell geschaltet sind. Jedes der Halbschaltermodule 52 besteht aus einer Parallelschaltung eines IGBTs 57 und einer Diode 56 als Freilaufdiode.

Der dreiphasige Schalter 50 ist auf mehrere verschiedene Arten modularisierbar. So ist es möglich, den dreiphasigen Schalter 50 aus einem Teilsubstrat 10 aufzubauen, das sechs Anschlussklemmen 58 aufweist. Weiterhin würde eine zweite Teilschaltung 10 verwendet, die sechs Dioden 56 aufweist und eine dritte Teilschaltung 10, die sechs IGBTs 57 aufweist. Eine weitere mögliche Methode besteht darin, drei Teilschaltungen 10 einzusetzen, die jeweils einen einphasigen Schalter 51 realisieren. Jede dieser Teilschaltungen 10 würde also zwei Anschlussklemmen 58, zwei Dioden 56 und zwei IGBTs 57 aufweisen. Bei Verwendung dieser Aufteilung in Teilschaltungen 10 könnten also zur Realisierung des dreiphasigen Schalters 50 drei identische Teilschaltungen 10 zum Einsatz kommen. Eine weitere grundsätzliche Möglichkeit besteht darin, die Anschlussklemmen 58 nicht in die Teilschaltungen 10 zu integrieren, sondern direkt auf den unterliegenden Träger, in diesem Fall das Kühlelement 23, aufzubringen.

Für den dreiphasigen Schalter 50 sowie auf das im Folgenden beschriebene Umrichtersystem 60 wird jedoch im Folgenden eine dritte Ausführungsmöglichkeit beschrieben, die darin besteht, sechs Teilsubstrate 10 zu verwenden, wobei jedes der Teilsubstrate 10 eine Anschlussklemme 58, eine Diode 56 und einen IGBT 57 aufweist. Um gewünschte elektrische Eigenschaften wie Widerstand, Spannungsfestigkeit o.a. zu erreichen, können statt der einzelnen Bauelemente auch Schaltungen mehrerer Bauelemente verwendet werden. So kann statt der einzelnen Diode 56 auch eine Serienschaltung von typischerweise gleichartigen Dioden 56 verwendet werden. Der IGBT 57 kann auch durch eine Parallelschaltung mehrerer IGBTs 57 ersetzt werden. Natürlich kann die Schaltung auch aus verschiedenartigen Bauelementen bestehen.

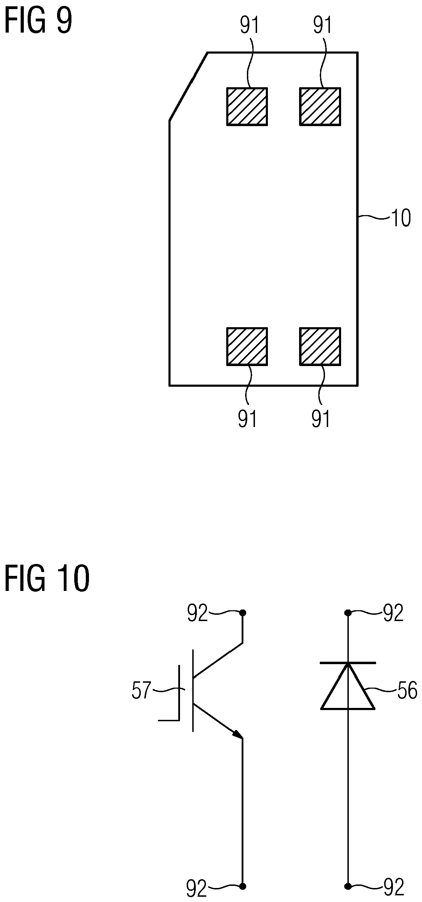

Zur Verdeutlichung zeigt Figur 9 schematisch eine Draufsicht auf eine der Teilschaltungen 10. Gemäß Figur 10 sind auf der Teilschaltung eine Diode 56 und ein IGBT 57 ohne elektrische Verbindung zueinander angeordnet. Die Diode 56 weist zwei Anschlusspunkte 92 für den elektrischen Anschluss auf. Der IGBT 57 wiederum weist eigentlich vier elektrische Anschlüsse auf. Für eine bessere Übersichtlichkeit der Darstellung sind jedoch nur zwei elektrische Anschlusspunkte 92 gezeigt. Gemäß Figur 10 sind für die elektrischen Anschlusspunkte 92 insgesamt vier Kontaktflächen 91 vorgesehen. Bei vollständiger Ausführung müssten es sechs Kontaktflächen 91 sein wegen der eigentlich vier elektrische Anschlüsse des IGBTs 57. Zweckmäßig wird im Schichtaufbau 22 im Dielektrikum 31 für jede Kontaktfläche 91 ein Fenster vorgesehen, durch das die flächige Kupferleiterbahn 32 die Kontaktflächen 91 elektrisch kontaktieren kann. Es wird darauf hingewiesen, dass das Dielektrikum 31 und die isolierende Deckschicht 33 in den Figuren 5 bis 9 aus Gründen der Übersicht weggelassen wurden.

Im Beispiel gemäß Figur 9 wird davon ausgegangen, dass zwischen der Diode 56 und dem IGBT 57 keine elektrische Verbindung auf Teilschaltungsebene vorgenommen wird. Die Teilschaltung 10 gemäß der Figur 9 weist dadurch die größte Flexibilität auf. Allerdings müssen alle nötigen elektrischen Verbindungen nachträglich in der vollständigen Schaltung erstellt werden, was den dortigen Aufbau der Kupferleiterbahn 32 komplex werden lassen kann. Es ist daher in einer Alternativ zur Möglichkeit gemäß Fig. 9 auch möglich, die zwei Paare von Kontaktflächen 91 bereits auf der Teilschaltung 10 elektrisch zu verbinden und somit eine Parallelschaltung von Diode 56 und IGBT 57 zu erzwingen. Dadurch wird die Flexibilität der Teilschaltung 10 erheblich reduziert, aber im Gegenzug die nachträgliche Verschaltung mehrerer Teilschaltungen 10 vereinfacht.

Ein möglicher Kompromiss besteht darin, nur eines der Paare von Kontaktflächen 91 zu verbinden. Hierdurch besteht weiterhin die Möglichkeit, den IGBT 57 oder die Diode 56 nicht zu verwenden, indem ihr jeweils anderer elektrischer Anschlusspunkt 92 offen gelassen wird. Trotzdem wird die weitere Verschaltung der Teilschaltungen 10 etwas vereinfacht.

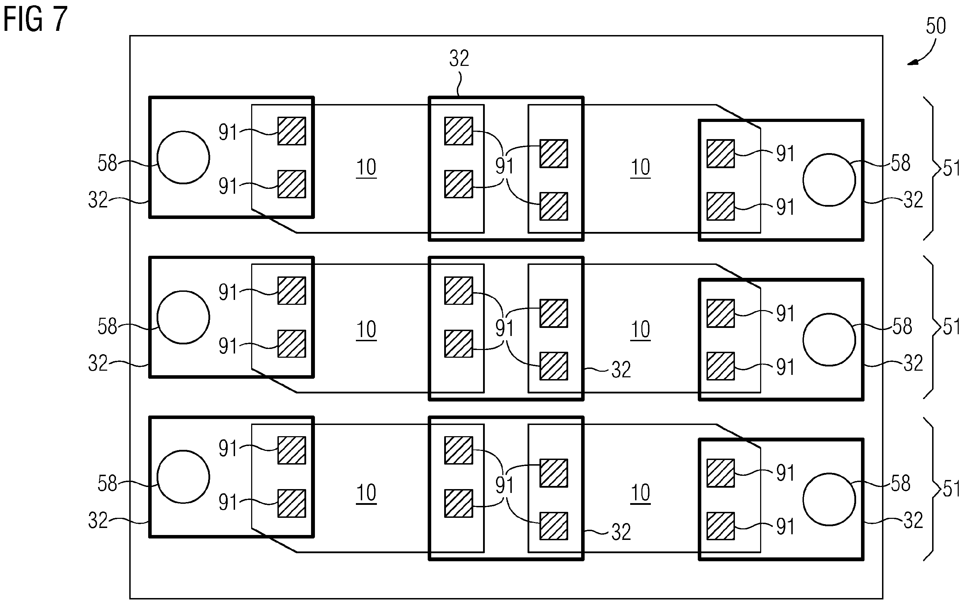

Unter der Voraussetzung, dass auf der Teilschaltung 10 erstmal keinerlei elektrische Verbindungen vorgesehen werden, ergibt sich ein in Figur 7 gezeigter Aufbau des dreiphasigen Schalters 50. Figur 7 zeigt in der Draufsicht den Kühlkörper 23, auf dem die Teilschaltungen 10 aufgebracht sind. Die sechs identischen Teilschaltungen 10 sind dabei auf dem Kühlkörper 23 in zwei Spalten zu jeweils drei Teilschaltungen 10 angeordnet. Jede Zeile aus zwei Teilschaltungen 10 dieser Anordnung realisiert einen einphasigen Schalter 51. Gemäß Figur 7 sind die Teilschaltungen 10, die einen einphasigen Schalter 51 realisieren, dabei so angeordnet, dass eine der beiden Teilschaltungen 10 um 180° rotiert ist. Hierdurch wird die elektrische Realisierung der Antiserienverschaltung vereinfacht.

Auch für diese gezeigte Anordnung gemäß der Figur 7 bestehen weite Variationsmöglichkeiten. So kann auf die rotierte Anordnung von drei der Teilschaltungen 10 verzichtet werden und dennoch eine antiserielle Schaltung über eine entsprechende flächige Kupferleiterbahn 32 erreicht werden. Auch ist die Anordnung der Teilschaltungen 10 in dem 2x3-Raster nicht notwendig. Auch kann der Abstand der Teilschaltungen 10 größer oder kleiner gewählt werden.
Im hier gegebenen Beispiel sowie auch beim nachfolgend beschriebenen Umrichter 60 wird davon ausgegangen, dass in den Teilschaltungen 10 keine elektrischen Verbindungen realisiert sind. Das bedeutet, dass die Diode 56 und der IGBT 57 erst über die flächige Kupferleiterbahn 32 kontaktiert werden. Dies ist vorteilhaft, da mit der flächigen Kupferleiterbahn 32 auch gleichzeitig die elektrische Verbindung zwischen den Teilschaltungen 10 hergestellt wird und somit zur elektrischen Verschaltung der Teilschaltungen 10 und des dreiphasigen Schalters 50 nur ein einzelner Schritt erforderlich ist. Eine gesonderte Verdrahtung jeder der Teilschaltungen 10 entfällt. Die in Figur 7 dargestellten flächigen Kupferleiterbahnen 32 dienen also der Verbindung von Diode 56 und IGBT 57 jeder der Teilschaltungen 10 zu jeweils einer Parallelschaltung, der antiseriellen Verbindung von je zwei dieser Parallelschaltungen und der Verbindung zu den Anschlussklemmen 58.
Hierbei ist zu beachten, dass die oben genannten Ausführungsform nur als Beispiel zu sehen ist. Bei leistungselektronischen Schaltern muss regelmäßig die Unterseite der Chips angeschlossen werden. Dies geschieht dabei üblicherweise durch die Kupferleiterbahn auf der Oberseite des DCB.
Somit ist durch die Verwendung von sechs identischen Teilsubstraten 10 ein dreiphasiger Schalter 50 realisiert.
Im Folgenden wird als weitere beispielhafte Ausführungsmöglichkeit für ein Umrichtersystem 60 gezeigt. Das Umrichtersystem 60 weist drei Anschlussklemmen 58 als Eingänge auf. Diese sind verbunden mit jeweils einer Kommutierungsdrossel 61. Die Kommutierungsdrosseln 61 sind wiederum mit je einem Strang einer ersten IGBT-Brücke 63 verbunden. Zwei Ausgänge der ersten IGBT-Brücke 63 sind mit einem Zwischenkreiskondensator 62 und parallel dazu mit zwei Anschlüssen einer zweiten IGBT-Brücke 64 verbunden. Von der zweiten IGBT-Brücke 64 führen Abgriffe zu drei Anschlussklemmen 58 als Ausgänge.

Die erste und die zweite IGBT-Brücke 63, 64 bestehen dabei aus jeweils drei Halbbrücken 67. Die Halbbrücken 67 bestehen wiederum jeweils aus zwei Halbschaltermodulen 52, die wie auch beim dreiphasigen Schalter 50 aus jeweils einem IGBT 57 und einer parallel dazu geschalteten Diode 56 bestehen. Im Falle der Halbbrücke 67 des Umrichtersystems 60 sind die Halbschaltermodule 52 der Halbbrücken 67 jedoch in Serie geschaltet, nicht antiseriell. Abgriffe in der Mitte der Halbbrücken 67 der ersten IGBT-Brücke 63 führen dabei einzeln zu den Kommutierungsdrosseln 61, während Mittelabgriffe der Halbbrücken 67 der zweiten IGBT-Brücke 64 zu den Anschlussklemmen 58 des Ausgangs führen. Die Halbbrücken 67 der ersten und zweiten IGBT-Brücke 63, 64 sind sämtlich außenseitig parallel geschaltet und sind weiterhin parallel zum Zwischenkreiskondensator 62 geschaltet.

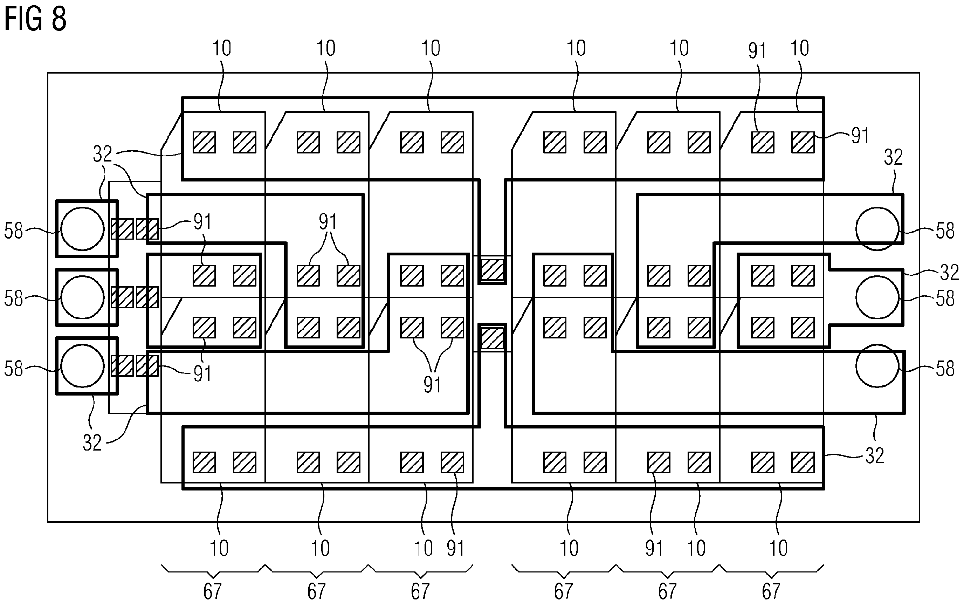

Die modularisierte Form des Umrichtersystems 60 mit Teilschaltungen 10 und flächigen Kupferleiterbahnen 32 ist in Figur 8 schematisch dargestellt. Die modularisierte Schaltung besteht aus zwölf der Teilschaltungen 10, die auch beim dreiphasigen Schalter 50 zum Einsatz gekommen sind. Zusätzlich ist in der modularisierten Schaltung eine Drossel-Teilschaltung 81 vorgesehen, die die Kommutierungsdrosseln 61 enthält. Flächige Kupferleiterbahnen 32 sorgen gemäß Figur 8 für eine entsprechende Verschaltung und elektrische Verbindung zwischen den Teilschaltungen 10 und auf den Teilschaltungen 10. Wie auch beim dreiphasigen Schalter 50 bestehen auch für die Modularisierung des Umrichtersystems 60 mehrere Möglichkeiten. Die gezeigte Möglichkeit gemäß Figur 8 wurde gewählt, da die Teilschaltungen 10, die die Halbschaltermodule 51 enthalten, sowohl beim dreiphasigen Schalter 50 als auch beim Umrichtersystem 60 verwendet werden können. Es können hier also mit völlig identischen Teilschaltungen 10 verschiedene elektronische Schaltungen aufgebaut werden, wobei beim Umrichtersystem 60 noch einige zusätzliche Komponenten notwendig sind.

Alternativ wäre es beim Umrichtersystem 60 beispielsweise möglich, eine Teilschaltung 10 für jede der Halbbrücken 67 vorzusehen. Würden dabei auf dieser Teilschaltung alle vier Komponenten, d.h. die zwei Dioden 56 und die zwei IGBTs 57 ohne elektrische Verbindung belassen, so könnten auch diese Teilschaltungen beim dreiphasigen Schalter 50 verwendet werden. Dabei müssten beim dreiphasigen Schalter 50 und beim Umrichtersystem 60 jedoch verschiedene elektrische Verschaltungen auf dieser Teilschaltung mittels der flächigen Kupferleiterbahn 32 erfolgen, um die serielle bzw. antiserielle Anordnung der Halbschaltermodule 52 zu realisieren.

Weitere Möglichkeiten der Modularisierung sowohl beim Umrichtersystem 60 als auch beim dreiphasigen Schalter 50 bestehen darin, beispielsweise beim Umrichtersystem 60 eine Teilschaltung 10 für jeweils eine der Kommutierungsgruppen 642, 643 zu verwenden. Da diese ebenso wie die Halbbrücken 67 funktionell aus einer Diode 56 und einem IGBT 57 bestehen, würde sich das beim gegebenen Beispiel nicht auf die Teilschaltungen 10 auswirken. Für die elektrische Verschaltung, d.h. die flächige Kupferleiterbahn 32, ergäbe sich jedoch eine andere Form, da andere elektrische Verbindungen nötig wären. Beim Schalter 50 könnte statt dem Halbschaltermodul 52 eine Strombahn 54 durch ein Teilschaltung 10 realisiert werden, was - in diesem Fall - ebenfalls zu keiner Änderung der Teilschaltung 10, aber zu einer Änderung des Layouts der Kupferleiterbahn 32 führen würde.

Letztlich muss für die Modularisierung einer elektronischen Schaltung 50, 60 in Teilschaltungen 10 ein Kompromiss gefunden werden zwischen der Wiederverwendbarkeit der Teilschaltungen 10, der Größe dieser Teilschaltungen 10, der Gesamtgröße der elektronischen Schaltung und der Komplexität der nötigen flächigen Kupferleiterbahnen 32. Gerade bei der Leistungselektronik kommen hierbei auch die besonderen Vorteile bezüglich der besseren Wärmespreizung und der geringeren Anforderungen an Kühlkörper und DCB besonders zur Geltung.

## Patentansprüche

1. Herstellungsverfahren für eine elektronische Schaltung (50, 60), bei dem:
- in einem ersten Schritt wenigstens zwei elektronische Teilschaltungen (10) hergestellt werden, wobei die Teilschaltungen (10) jeweils mehrere elektronische Bauelemente (11, 56, 57) auf einem separaten isolierenden Teil-Träger (14) aufweisen;
- in einem zweiten Schritt die Teilschaltungen (10) nebeneinander auf einem gemeinsamen Träger (23) angeordnet werden; und
- in einem dritten Schritt die Teilschaltungen (10) mit einem Verfahren zur flächigen Kontaktierung elektrisch verbunden werden, wobei das Verfahren wenigstens das Abscheiden einer metallischen Schicht (32) umfasst,
wobei im ersten Schritt wenigstens zwei identische Teilschaltungen (10) in einem gemeinsamen Prozess hergestellt werden und allein oder zusammen mit weiteren Teilschaltungen (10) zur elektronischen Schaltung (50, 60) verbunden werden.

2. Herstellungsverfahren gemäß Anspruch 1, bei dem in den Teilschaltungen (10) Bauteile der Leistungselektronik (57) verwendet werden und somit eine leistungselektronische Schaltung (50, 60) hergestellt wird.

3. Herstellungsverfahren gemäß Anspruch 1 oder 2, bei dem mit dem Verfahren zur flächigen elektrischen Kontaktierung auch eine oder mehrere elektrische Verbindungen innerhalb der Teilschaltungen (10) hergestellt werden.

4. Herstellungsverfahren gemäß einem der vorangehenden Ansprüche, bei dem mit dem Verfahren zur flächigen elektrischen Kontaktierung auch elektrische Verbindungen zu Anschlussklemmen (58) hergestellt werden.

5. Herstellungsverfahren gemäß einem der vorangehenden Ansprüche, bei dem als gemeinsamer Träger (23) ein Kühlkörper (23) verwendet wird.

6. Herstellungsverfahren gemäß einem der vorangehenden Ansprüche, bei dem das Verfahren zur flächigen Kontaktierung die Schritte aufweist:
- Aufbringen einer Isolationsfolie (31) zur elektrischen Isolation auf den gemeinsamen Träger (23) und die Teilschaltungen (10);
- Öffnen von Fenstern in der Isolationsfolie (31);
- Aufbringen einer metallischen Starterschicht;
- galvanisches Aufbringen der metallischen Schicht (32) auf die Isolationsfolie (31).

7. Herstellungsverfahren gemäß Anspruch 6, bei dem beim Verfahren zur flächigen Kontaktierung zusätzlich nach dem Aufbringen der metallischen Schicht (32) eine weitere elektrisch isolierende Schicht (33) aufgebracht wird.

8. Herstellungsverfahren gemäß einem der vorangehenden Ansprüche, bei dem Halterungen (44) auf dem gemeinsamen Träger (23) zur Verankerung der Teilsubstrate (10) verwendet werden.

9. Herstellungsverfahren gemäß einem der vorangehenden Ansprüche, bei dem als elektronische Bauelemente (11, 56, 57) wenigstens ein IGBT (57) und wenigstens eine Diode (56) verwendet werden und als elektronische Schaltung (50, 60) ein Umrichter (60) oder Schalter (50) hergestellt wird.

## Claims

1. Production method for an electronic circuit (50, 60), wherein:
- in a first step, at least two electronic sub-circuits (10) are produced, the sub-circuits (10) each having a plurality of electronic components (11, 56, 57) on a separate insulating sub-carrier (14);
- in a second step, the sub-circuits (10) are arranged alongside one another on a common carrier (23); and
- in a third step, the sub-circuits (10) are electrically connected by means of a method for planar contact-connection, the method comprising at least the deposition of a metallic layer (32),
wherein, in the first step, at least two identical sub-circuits (10) are produced in a common process and are connected alone or together with further sub-circuits (10) to form the electronic circuit (50, 60).

2. Production method according to Claim 1, wherein components appertaining to power electronics (57) are used in the sub-circuits (10) and a power electronic circuit (50, 60) is thus produced.

3. Production method according to Claim 1 or 2, wherein one or a plurality of electrical connections within the sub-circuits (10) are also produced by means of the method for planar electrical contact-connection.

4. Production method according to any of the preceding claims, wherein electrical connections to connecting terminals (58) are also produced by means of the method for planar electrical contact-connection.

5. Production method according to any of the preceding claims, wherein a heat sink (23) is used as the common carrier (23) .

6. Production method according to any of the preceding claims, wherein the method for planar contact-connection has the following steps:
- applying an insulation film (31) for electrical insulation to the common carrier (23) and the sub-circuits (10);
- opening windows in the insulation film (31);
- applying a metallic starter layer;
- electrolytically applying the metallic layer (32) to the insulation film (31).

7. Production method according to Claim 6, wherein, in the method for planar contact-connection, a further electrically insulating layer (33) is additionally applied after the metallic layer (32) has been applied.

8. Production method according to any of the preceding claims, wherein mounts (44) on the common carrier (23) are used for anchoring the sub-substrates (10).

9. Production method according to any of the preceding claims, wherein at least one IGBT (57) and at least one diode (56) are used as electronic components (11, 56, 57) and a converter (60) or switch (50) is produced as the electronic circuit (50, 60).

## Revendications

1. Procédé de fabrication d'un circuit (50, 60) électronique, dans lequel :
- dans un premier stade, on fabrique au moins deux sous-circuits (10) électroniques, les sous-circuits (10) ayant chacun plusieurs composants (11, 56, 57) électroniques sur un sous-support (14) distinct isolant;
- dans un deuxième stade, on met les sous-circuits (10) les uns à côté des autres sur un support (23) commun; et
- dans un troisième stade, on relie électriquement les sous-circuits (10) par un procédé de mise en contact en surface, le procédé comprenant au moins le dépôt d'une couche (32) métallique,
dans lequel dans le premier stade, on produit au moins deux sous-circuits (10) identiques dans un processus commun et on les relie seul ou ensemble à d'autres sous-circuits (10) en le circuit (50, 60) électronique.

2. Procédé de fabrication suivant la revendication 1, dans lequel on utilise dans les sous-circuits (10) des composants de l'électronique (57) de puissance et on fabrique ainsi un circuit (50, 60) d'électronique de puissance.

3. Procédé de fabrication suivant la revendication 1 ou 2, dans lequel on produit par le procédé de mise en contact électrique en surface également une ou plusieurs liaisons électriques au sein des sous-circuits (10).

4. Procédé de fabrication suivant l'une des revendications précédentes, dans lequel on produit par le procédé de mise en contact électrique en surface également des liaisons électriques à des bornes (58).

5. Procédé de fabrication suivant l'une des revendications précédentes, dans lequel on utilise un puits de chaleur (23) comme support (23) commun.

6. Procédé de fabrication suivant l'une des revendications précédentes, dans lequel le procédé de mise en contact en surface comprend les stades :
- dépôt d'une feuille (31) isolante pour l'isolation électrique sur le support (23) commun et les sous-circuits (10);
- ouverture de fenêtres dans la feuille (31) isolante;
- dépôt d'une couche métallique de starter;
- dépôt galvanique de la couche (32) métallique sur la feuille (31) isolante.

7. Procédé de fabrication suivant la revendication 6, dans lequel, lors du procédé de mise en contact en surface, on dépose supplémentairement après le dépôt de la couche (32) métallique, une autre couche (33) isolante du point de vue électrique.

8. Procédé de fabrication suivant l'une des revendications précédentes, dans lequel on utilise des fixations (44) sur le support (23) commun pour ancrer les sous-substrats (10).

9. Procédé de fabrication suivant l'une des revendications précédentes, dans lequel on utilise comme composant (11, 56, 57) électronique au moins un IGBT (57) et au moins une diode (56) et on fabrique comme circuit (50, 60) électronique un convertisseur (60) ou un interrupteur (50).
